(19) Europäisches Patentamt

European Patent Office

Office européen des brevets

(11) **EP 1 489 387 B1**

(12) **FASCICULE DE BREVET EUROPEEN**

(45) Date de publication et mention
de la délivrance du brevet:
**06.09.2006 Bulletin 2006/36**

(51) Int Cl.:
***G01D 5/244*** *(2006.01)*  ***H03M 1/30*** *(2006.01)*
***G01D 5/347*** *(2006.01)*

(21) Numéro de dépôt: **04291492.9**

(22) Date de dépôt: **15.06.2004**

(54) **Procédé d'interpolation angulaire réalisé pour un codeur optique à haute résolution et le codeur optique correspondant**

Interpolationsverfahren für einen hochauflösenden optischen Winkelgeber und zugehöriger optischer Winkelgeber

Interpolation method for high resolution angular encoder and corresponding optical encoder

(84) Etats contractants désignés:
**AT BE BG CH CY CZ DE DK EE ES FI FR GB GR HU IE IT LI LU MC NL PL PT RO SE SI SK TR**
Etats d'extension désignés:
**LT LV**

(30) Priorité: **19.06.2003 FR 0307406**

(43) Date de publication de la demande:
**22.12.2004 Bulletin 2004/52**

(73) Titulaire: **Codechamp S.A.**
**23190 Champagnat (FR)**

(72) Inventeur: **Gaumet, Daniel**
**23190 Champagnat (FR)**

(74) Mandataire: **Debay, Yves**
**Cabinet Debay,**
**126 Elysée 2**
**78170 La Celle Saint Cloud (FR)**

(56) Documents cités:
**EP-A- 0 200 791       EP-A- 0 395 936**
**EP-B- 0 591 550       US-A- 5 041 829**

**Description**

La présente invention concerne un procédé d'interpolation angulaire réalisé par un codeur optique haute résolution, permettant d'effectuer une mesure angulaire précise.

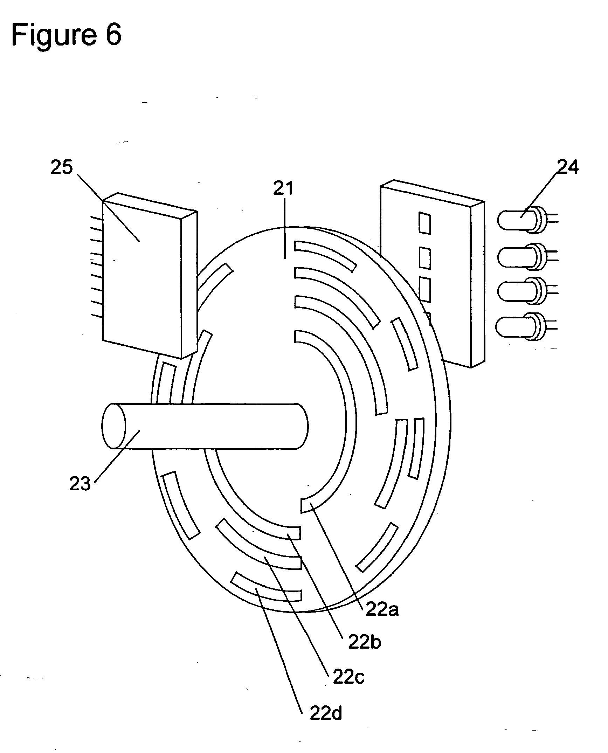

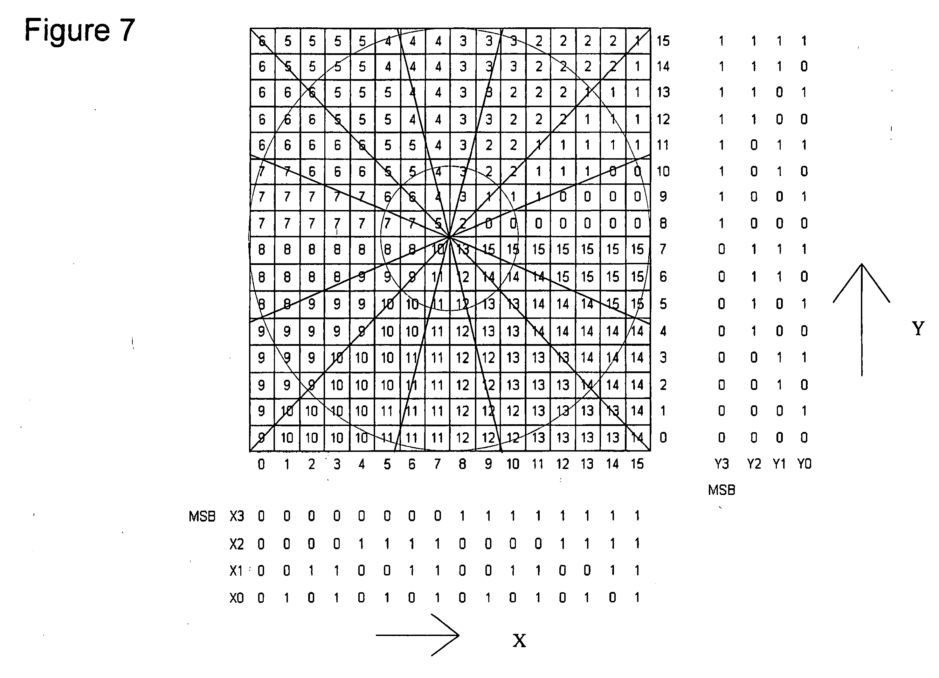

Selon la figure 6, il est connu dans l'art antérieur, qu'un codeur optique de type absolu comporte un disque solidaire (21) de l'axe (23) dont l'on veut mesurer l'angle de rotation. Ce même disque (21) présente des pistes circulaires concentriques (22a, 22b et 22c), elles-mêmes comportant des zones alternativement opaques et transparentes. Ces zones sont de dimensions égales sur une piste donnée et forment des secteurs angulaires de plusieurs degrés et identiques sur chaque piste. Une lumière en provenance par exemple d'une batterie de diodes laser (24), éclaire chaque piste (22a, 22b et 22c).Le signal optique de sortie est converti en signal électrique analogique par une batterie de capteurs (25), par exemple de type photodiodes. Lorsqu'un photorécepteur reçoit les rayons lumineux, il produit un signal électrique analogique, en général, proche d'un signal sinusoïdal. Ce signal est ensuite traité par l'intermédiaire d'un convertisseur analogique / numérique ou tout autre procédé, tel qu'une méthode d'interpolation, pour obtenir un signal en créneau. La position angulaire du disque est définie par un mot binaire. Une méthode d'interpolation, connue de l'art antérieur, est représentée sur la figure 7. Cette méthode consiste en un calcul statique entre les valeurs d'un signal sinus (Y) et d'un signal cosinus (X). Ce calcul statique est réalisé par le biais d'un tableau (30) de classification de données dont les valeurs de l'angle à calculer sont prédéfinies par rapport à des valeurs de sinus et de cosinus. Ce tableau est stocké dans une mémoire de données. Un inconvénient de ce procédé d'interpolation est que, pour obtenir une meilleure précision de l'angle, il faut augmenter la taille du tableau, qui va alors prendre plus de place dans la mémoire.

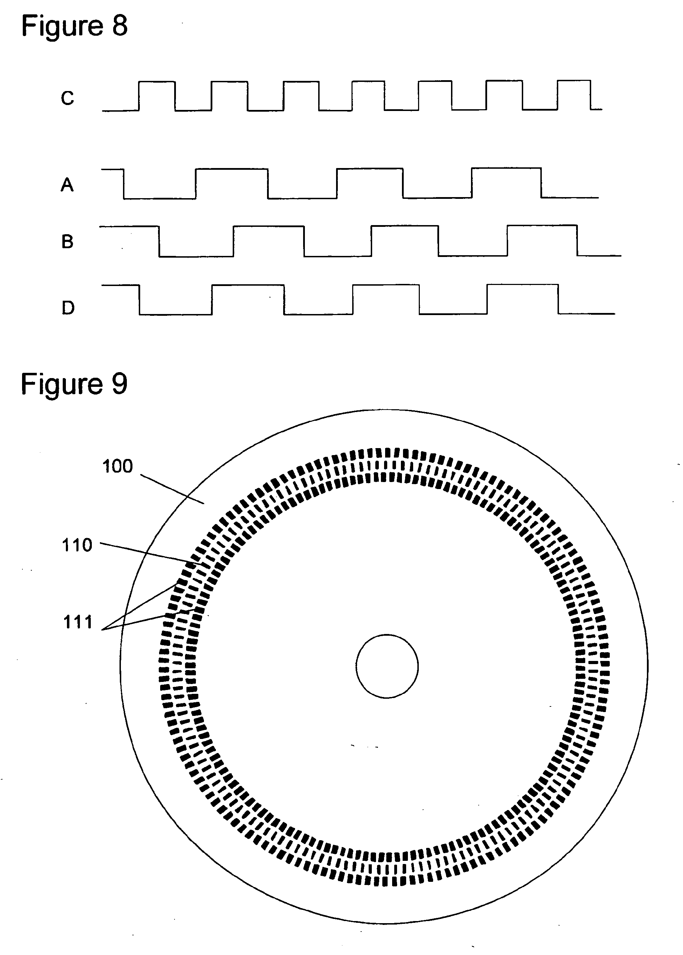

Il est également connu dans l'art antérieur, que la résolution d'un codeur optique est déterminée par la précision avec laquelle le codeur est fabriqué et monté. La précision est également limitée par la précision des gravures de la piste fine, des effets de bord de la fenêtre de précision, de la précision des capteurs et du décentrage et du voilage du disque. Afin de remédier à ces imprécisions de montage, il est connu un système décrit par le brevet FR 9908159, permettant d'enrichir le mot binaire résultant de la lecture d'une première piste, dite piste fine, par des bits supplémentaires obtenus par une opération de levée de doute en V. Cette opération est réalisée par l'intermédiaire du traitement d'un signal produit par au moins une paire de récepteurs effectuant la lecture d'au moins une paire de pistes supplémentaires. En référence à la figure 9, ce codeur optique haute résolution comprend un disque (100), lui-même comportant au moins une piste fine (110) et des pistes voisines (111).La piste fine (110) est lue par quatre photodétecteurs disposés deux à deux opposés et chaque groupe de deux décalés de 90° sur le disque (100).A la lecture de cette piste, les photorécepteurs convertissent des signaux optiques en des signaux analogiques présentant au moins un signal de type sinus et un signal de type cosinus. Ces signaux vont être ensuite traités dans un convertisseur analogique / numérique, puis vont être traités dans un calculateur effectuant par exemple un calcul d'interpolation. On obtient un premier mot binaire comportant par exemple 10 bits, dont le bit de poids faible correspond à un signal en créneau C. Pour obtenir une meilleure correction par exemple des erreurs de décentrage du disque, le mot binaire est enrichi d'au moins un bit de levée de doute. Plus le mot binaire contient de bits de levée de doute, plus la résolution du codeur est bonne. En référence à la figure 8, un bit de levée de doute est produit par la lecture d'une paire de pistes supplémentaires situées par exemple de part et d'autre de la piste fine. Chaque piste voisine est lue par un photodétecteur. Le signal électrique produit par chaque photorécepteur des pistes voisines est également traité pour obtenir un signal en créneau. On obtient deux signaux en créneaux respectivement, A et B, décalés entre eux d'une demi-période. Une mémoire programmable effectue l'équation algorithmique de la levée de doute entre le signal fourni par la piste fine et ceux fournis par les pistes voisines. Cette équation est la suivante : « Si C=1 alors D=A sinon D=B », D étant le bit résultant de la levée de doute. La figure 8 représente les chronogrammes représentatifs des différents signaux, A, B, C et D. On obtient un bit de levée de doute D permettant d'enrichir le mot binaire obtenu par la lecture de la piste fine. En référence au brevet FR 9908159, on peut également enrichir le mot binaire en minimisant le nombre de photo-détecteurs, disposés sur le disque. Ainsi avec 4 photo-détecteurs, on peut obtenir 3 bits de levée de doute. Cette amélioration est obtenue par des calculs de logique combinatoire et l'équation de la levée de doute précédemment citée. Cependant, pour un mot binaire de 26 bits par exemple il faut, 4 photo-détecteurs pour lire la piste fine qui fournit, par exemple un mot de 10 bits, et pour obtenir les bits de levée de doute restant, il faut au moins 30 photo-détecteurs. Il peut s'avérer nécessaire de doubler le nombre de photo-détecteur, permettant ainsi de réaliser une moyenne sur les résultats obtenus. Cette moyenne permet d'obtenir une meilleure précision du résultat. Ce nombre important de photo-détecteurs, utilisés pour la lecture de la piste fine et des pistes supplémentaires, est un inconvénient majeur de ce codeur optique de haute résolution.

Il est également connu, par le document US 5 041 829, une méthode d'interpolation entre deux signaux, dans laquelle chaque signal converti numériquement est utilisé pour adresser une mémoire dont chaque adresse correspond à un résultat d'interpolation préenregistré pour une combinaison particulière des valeurs du signal. Ce type de méthode, qui requiert des mémoires et un moyen d'adressage, ne permet pas d'obtenir une mesure angulaire très précise sans augmenter la taille du tableau de classification prévu en mémoire. Les documents EP 0 591 550 et EP 0 395 936 se rapportent aussi à des codeurs utilisant plusieurs détecteurs mais ne permettant pas d'effectuer une mesure angulaire précise de façon optimale.

La présente invention a pour but de pallier certains inconvénients de l'art antérieur en proposant un procédé d'interpolation angulaire, par calcul dynamique, associé à un codeur optique haute résolution. Ce procédé permet de diminuer le nombre de portes logiques dont les signaux sont utilisés par le codeur. Le codeur optique propose, en utilisant ce procédé d'interpolation angulaire, de diminuer le nombre de photodétecteurs utilisés pour la lecture des pistes internes du disque du codeur optique haute résolution.

Ce but est atteint par un procédé d'interpolation angulaire, effectué par un codeur optique, ledit codeur optique comprenant au moins, un disque comportant au moins une piste circulaire concentrique formée par des zones alternativement opaques et transparentes, une source lumineuse éclairant la piste, des capteurs permettant de convertir un signal optique généré par la source lumineuse et le disque en un signal analogique, un moyen de convertir un signal analogique en un signal numérique et un calculateur réalisant le traitement des données, le procédé d'interpolation angulaire est caractérisé en ce qu'il comprend les étapes suivantes :

- la lecture et la saisie des valeurs numériques $Y_0$ et $X_0$ des signaux générés par la source lumineuse et la piste circulaire, les signaux analogiques étant numérisés par un moyen de convertir un signal analogique en un signal numérique,

- le calcul dynamique de l'interpolation angulaire réalisé sur une période angulaire allant de -90° à 90°, ledit calcul d'interpolation étant sensiblement équivalent à un calcul par itération, avec chaque itération « i » comprenant, la détermination d'un signe « d » en fonction de valeurs $X_{i-1}$ et $Y_{i-1}$ précédemment calculées ou lues dans l'itération « i-1 » précédente, le calcul de nouvelles valeurs $X_i$ et $Y_i$ permettant de déterminer le signe « d » à utiliser dans la prochaine itération « i+1 », et le calcul d'une valeur $Z_i$ s'approchant, à chaque itération, de la valeur finale de l'angle à connaître.

- la détermination de la zone de 180° situant la position de l'angle, permettant d'obtenir un résultat sur une période angulaire de 360°, ledit résultat étant présenté par un mot binaire comprenant un nombre de bits prédéfinis.

Selon une autre particularité, le procédé d'interpolation angulaire effectue la saisie de données numériques $Y_0$ et $X_0$ lors de la première étape du calcul d'interpolation angulaire, lesdites données numériques résultant de la lecture de signaux sensiblement identiques à des signaux sinusoïdaux respectivement de type sinus et cosinus.

Selon une autre particularité, la valeur $X_i$ de l'itération « i », « i » étant différente de la valeur nulle, est calculée en fonction des valeurs $X_{i-1}$ et $Y_{i-1}$ calculées lors de l'itération « i -1 » précédente, et en fonction du signe « d », déterminé lors de l'itération « i ».

Selon une autre particularité, la valeur $Y_i$ de l'itération « i », « i » étant différente de la valeur nulle, est calculée en fonction des valeurs $X_{i-1}$ et $Y_{i-1}$ calculées lors de l'itération « i-1 » précédente, et en fonction du signe « d » déterminé lors de l'itération « i ».

Selon une autre particularité, le signe « d » est déterminé lors de l'étape de saisie des données, par un moyen de comparaison de la valeur des données numérique $Y_0$ et $X_0$' en fonction des conditions suivantes : d = 1 si $X_0 < 0$ et $Y_0 < 0$ sinon
d = -1.

Selon une autre particularité, le signe « d » est déterminé lors des itérations « i », « i » étant différente de la valeur nulle, par un moyen de comparaison de la valeur des données $X_{i-1}$ et $Y_{i-1}$ déterminées dans l'itération précédente « i-1 », en fonction des conditions suivantes : d = 1 si $X_{i-1} < 0$ et $Y_{i-1} < 0$ sinon d = -1.

Selon une autre particularité, la valeur $Z_i$ de l'itération « i », « i » étant différente de la valeur nulle, est calculée en fonction du signe « d » déterminé dans l'itération « i » et soit, d'une constante prédéfinie ou soit, de la valeur $Z_{i-1}$ calculée lors de l'itération « i-1 » précédente.

Selon une autre particularité, le nombre d'itérations est prédéfini, permettant ainsi de prédéfinir les constantes utilisées dans le calcul et ainsi de diminuer le temps de calcul d'interpolation réalisé par le calculateur, et de diminuer le nombre de portes logiques dont les signaux sont utilisés par le calculateur du codeur optique, tout en obtenant un résultat précis.

Selon une autre particularité, la valeur X ne varie plus et n'est plus calculée dès lors, qu'elle est égale à une valeur proche de zéro, ladite valeur X restant la même dans les itérations suivantes.

Selon une autre particularité, le procédé d'interpolation angulaire calcule les valeurs X, Y et Z pour obtenir des valeurs entières, les valeurs en décimales n'étant pas significatives pour la précision de l'angle, ledit calcul en valeur entière permettant de diminuer le nombre de portes logiques dont les signaux sont utilisés par le calculateur du codeur optique.

Selon une autre particularité, l'erreur de calcul, obtenue avec un tel procédé d'interpolation angulaire, est inférieure à 1.5en, sachant que $e = 2^{-b}$, b étant le nombre de bits utilisés pour représenter un nombre, et n étant égal au nombre d'itérations prédéfinies.

Selon une autre particularité, la zone de 180° situant la position de l'angle, est déterminée par le bit de poids fort d'un mot binaire obtenu par la conversion analogique numérique d'un signal sinusoïdal de type sinus ou cosinus résultant de la lecture de la piste, ladite conversion étant réalisée par le moyen de convertir un signal analogique en un signal numérique.

Un autre but est de proposer un codeur optique de haute résolution comprenant un disque comportant au moins deux pistes, dont une piste de division fine et une piste de division plus grossière, le partage en division de chaque piste étant un multiple de la piste précédente, les dites pistes sont lues chacune par quatre photodétecteurs permettant d'obtenir par piste, des signaux sensiblement sinusoïdaux décalés de 90° chacun, ces signaux étant ensuite numérisés par un moyen de convertir un signal analogique en un signal numérique pour obtenir des coordonnées initiales d'angle de positions qui sont directement envoyés vers un calculateur pour être traités, le codeur optique haute résolution étant caractérisé en ce que le calculateur effectue un procédé dynamique d'interpolation angulaire comportant en entrée les signaux sinusoïdaux générés par la lecture de chaque piste individuelle et convertis en signaux numériques, le calculateur produisant une valeur d'angle numérique pour chaque piste individuelle et comprenant des moyens d'itération pour réaliser ledit calcul sur une période angulaire allant de -90° à 90°, les moyens d'itération étant aptes, pour chaque itération « i », à :

- déterminer un signe « d » en fonction de valeurs numériques $X_{i-1}$ et $Y_{i-1}$ précédemment calculées ou lues dans l'itération « i-1 » précédente,
- calculer de nouvelles valeurs numériques Xi et Yi permettant de déterminer le signe « d » à utiliser dans la prochaine itération « i+1 », et,
- calculer une valeur $Z_i$ s'approchant, à chaque itération, de la valeur finale de l'angle à connaître,

le codeur optique incluant des moyens pour déterminer la zone de 180° situant la position de l'angle et générer un mot numérique représentant la position angulaire absolue du disque.

Selon une autre particularité, les moyens d'itération du calculateur comportent un moyen de déterminer dans une itération i l'opération, addition ou soustraction, de la coordonnée orthogonale à celle calculée dans l'itération précédente i-1, cette opération étant associée à une condition de détermination d'un signe obtenue par un moyen de comparaison des coordonnées de l'itération précédente avec une valeur constante et des moyens d'utiliser le signe de l'opération ainsi déterminée pour ajouter ou soustraire un coefficient dépendant du niveau d'itération à la valeur précédente d'angle pour obtenir une valeur d'angle à connaître.

Selon une autre particularité, le traitement des signaux numériques, de forme sensiblement sinusoïdale arrivant dans le calculateur, fournit un mot binaire correspondant à la lecture d'une piste, ledit mot binaire comprenant un premier bit représentatif de la variation des zones opaques et transparentes de la piste lue et les autres bits restants étant représentatifs de la valeur d'angle numérique fournie par un calcul dynamique d'interpolation angulaire.

Selon une autre particularité, les mots binaires, résultant du traitement des signaux numériques générés lors de la lecture de chaque piste individuelle, sont traités de manière combinatoire les uns aux autres, permettant d'obtenir un mot binaire final synchronisé, représentatif de la position angulaire absolue du disque, ledit mot binaire final étant constitué de telle sorte que les bits de poids faibles correspondent à la valeur angulaire représentative de la lecture de la piste de division la plus fine et les bits de poids fort correspondent à la valeur angulaire représentative de la lecture de la piste de division la moins fine.

Selon une autre particularité, le codeur optique de haute résolution comprend un moyen de convertir un signal analogique en un signal numérique multiplexé permettant de numériser les signaux de forme sensiblement sinusoïdale, générés par la lecture de chaque piste individuelle en fonction du multiplexage commandé par le calculateur.

Selon une autre particularité, le codeur optique de haute résolution comprend un système de traitement de données multiplexé, permettant de réaliser le même procédé dynamique d'interpolation angulaire à partir de tous les signaux sinusoïdaux générés par la lecture de chaque piste individuelle.

Selon une autre particularité, le codeur optique de haute résolution comprend un disque pouvant comporter plus de deux pistes, les pistes étant de division différente plus ou moins fine, et étant disposées les unes par rapport aux autres de manière concentrique sur le disque, permettant que le partage en division de chaque piste soit un multiple de la piste précédente.

Selon une autre particularité, la piste de division la moins fine permet de générer lors de sa lecture, au moins un signal de forme sensiblement sinusoïdale dont la période correspond à un tour de rotation du disque codé.

Selon une autre particularité, la piste de division la moins fine est de forme progressive, permettant de générer par sa lecture un signal de forme sensiblement sinusoïdale.

D'autres particularités et avantages de la présente invention apparaîtront plus clairement à la lecture de la description ci-après, faite en référence aux dessins annexés, dans lesquels :

- La figure 1 représente le schéma simplifié d'un disque codé, ledit schéma étant utilisé pour expliquer clairement les étapes du procédé dynamique d'interpolation angulaire, selon l'invention ;

- la figure 2 représente le schéma simplifié d'un système d'exploitation d'un codeur optique, ledit schéma étant utilisé pour expliquer clairement les étapes du procédé dynamique d'interpolation angulaire, selon l'invention;

- la figure 3 représente le schéma d'un disque codé, selon l'invention.

- la figure 4 représente un schéma spécifique de la composition d'un mot binaire comprenant la valeur numérique d'un angle, ledit mot binaire résultant du calcul dynamique d'interpolation angulaire, selon l'invention,

- la figure 5 représente le schéma du système d'exploitation du codeur optique de haute résolution utilisant le procédé dynamique d'interpolation angulaire de l'invention ;

- la figure 6 représente le schéma d'un codeur optique connu de l'art antérieur ;

- la figure 7 représente le schéma représentatif du procédé statique d'interpolation angulaire connu de l'art antérieur ;

- la figure 8 représente les chronogrammes représentatifs de l'équation de levée de doute en V connue de l'art antérieur ;

- la figure 9 représente une vue de disposition de pistes concentriques sur un disque codé, permettant de réaliser une levée de doute en V connue de l'art antérieur.

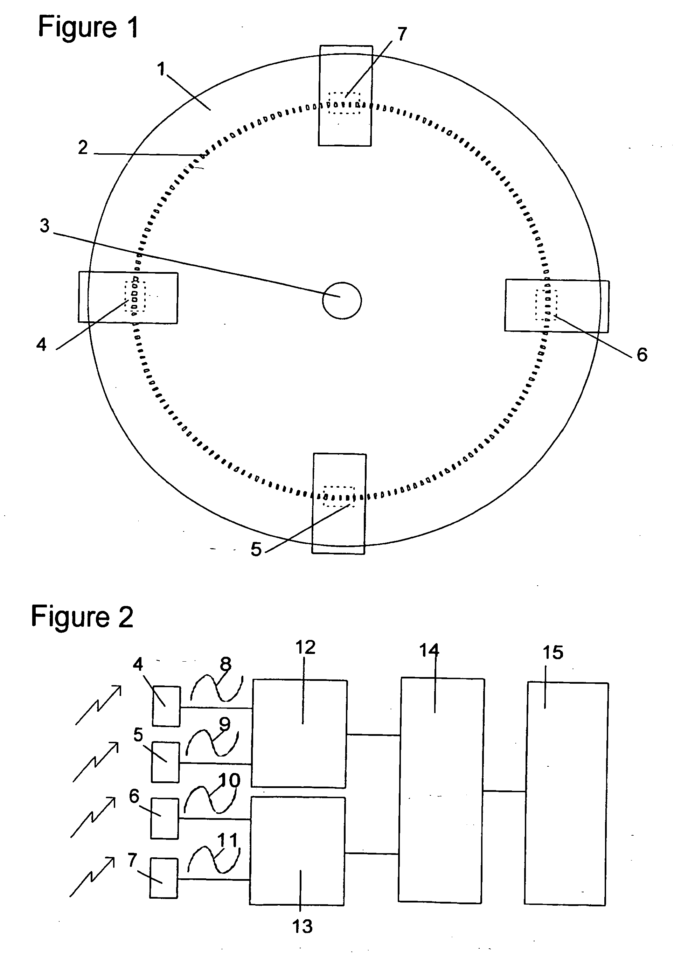

La présente invention concerne, en particulier, un procédé de calcul d'interpolation d'angle permettant de calculer l'angle formé, par exemple, par un bras mécanique autour d'un axe. En se référant aux figures 1 et 2, le codeur optique utilisé dans le début de la description est un codeur simplifié permettant une meilleure compréhension du procédé, selon l'invention. Ce codeur optique comprend un disque (1), disposé sur un axe (3), le disque comportant une piste fine (2), ladite piste étant lue par quatre photodétecteurs (4, 5, 6 et 7) disposés autour de la piste de manière à fournir, après lecture de la piste, des signaux sinusoïdaux déphasés de 90°. Les quatre signaux sinusoïdaux correspondent respectivement à un signal sinus (8), à un signal sinus inversé (9), à un signal cosinus (10) et à un signal cosinus inversé (11).Chaque paire de signal sinus (sinus et sinus inversé) et cosinus (cosinus et cosinus inversé) est ensuite comparé dans un amplificateur différentiel (12 et 13) pour en ressortir un signal sinus et un signal cosinus, obtenus sans un décalage généré par le courant continu. Ces deux signaux sont ensuite numérisés, par exemple, dans un convertisseur numérique analogique (14) et après numérisation, les signaux entrent dans un calculateur (15) qui réalise le procédé d'interpolation.

Le procédé de calcul d'interpolation, selon l'invention, comprend au moins trois étapes :

- une étape de saisie des valeurs initiales (X0, Y0),

- une étape de calcul d'interpolation angulaire en fonction des valeurs initiales (X0, Y0) comprenant également d'autres sous étapes, ledit calcul permettant d'obtenir un résultat angulaire positionné sur une période angulaire allant de -90° à 90°,

- et enfin une étape permettant d'obtenir le résultat de la valeur angulaire sur une période de 360°.

Le procédé, selon l'invention, réalise un calcul sensiblement équivalent à un calcul d'itération. Cependant les itérations, calculées dans la présente invention, ne sont pas identiques les unes des autres, permettant ainsi de travailler avec des constantes prédéfinis afin de minimiser ie temps de calcul et le nombre de portes logiques utilisées par le calculateur.

La première étape du procédé, selon l'invention, concerne la lecture et la saisie des valeurs numériques Y0 et X0 générées par le convertisseur analogique numérique. Ces valeurs correspondent respectivement aux valeurs numériques des signaux analogiques convertis. Ces valeurs représentent respectivement les valeurs numériques correspondant au signal cosinus (X0) et du signal sinus (Y0) lus par les phototransistors disposés sur la piste fine. Ainsi le bras mécanique représenté dans un plan orthogonal d'axe des ordonnées y et d'axe des abscisses x est à une position M. Le point M a pour coordonnées, le point d'intersection (X0) entre la droite droit passant par M orthogonale à l'axe x et l'axe y et le point d'intersection (Y0) entre la droite passant par M orthogonale à l'axe x et l'axe y.

La deuxième étape du procédé, selon l'invention, concerne le calcul de l'interpolation angulaire, permettant d'obtenir la valeur d'un angle, borné sur une période angulaire allant de « -90° » à « 90° ».

Ci-dessous, un exemple d'algorithme de ce calcul d'interpolation est présenté. Cet exemple correspond à un calcul d'interpolation permettant 13 itérations. Ce calcul peut être également réalisé avec un nombre d'itérations inférieur ou supérieur au nombre 13. La deuxième étape du procédé, selon l'invention, est décrite en référence à l'exemple présenté ci-dessous :

Itération numéro 1 :

$$X1=X0+d*Y0$$

$$Y1=Y0-d*X0$$

Itération numéro 2 :

$$X2= \gamma\_2*X1+d*Y1$$

$$Y2= \gamma\_2*Y1-d*X1$$

$$Z2=\alpha\_2+d*\beta\_2$$

Itération numéro 3 :

$$X3= \gamma\_3 *X2+d*Y2$$

$$Y3= \gamma\_3*Y2-d*X2$$

$$Z3= \gamma\_3*Z2+d* \beta\_3$$

Itération numéro 4 :

$$X4=X3+d*Entier(Y3/8)$$

$$Y4=Y3-d*Entier(X3/8)$$

$$Z4=Z3+d* \beta\_4$$

Itération numéro 5 :

$$X5 = Entier(X4/8) + d*Entier(Y4/128)$$

$$Y5 = \gamma\_5*Y4 - d*Entier(X4/8)$$

$$Z5 = Z4 + d* \beta\_5$$

Itération numéro 6 :

$$Y6 = \gamma\_6*Y5 - d*X5$$

$$Z6 = Z5 + d* \beta\_6$$

Itération numéro 7 :

$$Y7 = \gamma\_7*Y6 - d*X5$$

$$Z7 = Z6 + d* \beta\_7$$

Itération numéro 8 :

$$Y8 = \gamma\_8*Y7 - d*X5$$

$$Z8 = Z7 + d* \beta\_8$$

Itération numéro 9 :

$$Y9 = \gamma\_9*Y8 - d*X5$$

$$Z9 = Z8 + d* \beta\_9$$

Itération numéro 10 :

$$Y10 = \gamma\_10*Y9 - d*X5$$

$$Z10=Z9+d^*\ \beta\_10$$

Itération numéro 11 :

$$Y11=\gamma\_11^*Y10-d^*X5$$

$$Z11=Z10+d^*\ \beta\_11$$

Itération numéro 12 :

$$Y12=\gamma\_12^*Y11-d^*X5$$

$$Z12=Z11+d^*\ \beta\_12$$

Itération numéro 13 :

$$Y13=\gamma\_13^*Y12-d^*X5$$

$$Z13=Z12+d^*\ \beta\_13$$

Dans l'exemple ci-dessus, les données Xi et Yi correspondent à des valeurs calculées à partir des valeurs Xi-1 et Yi-1 calculées ou lues dans les itérations précédentes. La donnée « d » correspond à un signe, défini suivant les valeurs Xi-1 et Yi-1 calculées ou lues dans les itérations précédentes. La donnée Zi correspond à la valeur s'approchant à chaque calcul d'itération de la valeur de l'angle à connaître. Les valeurs $\gamma\_i$, $\alpha\_i$ et $\beta\_i$ sont des constantes prédéfinies. Pour réaliser ce procédé d'interpolation le calculateur comprend un moyen de détermination de l'opération, addition ou soustraction, des coordonnées de chaque axe x et y (Xi et Yi) dans l'itération i en fonction des coordonnées (Xi-1 et Yi-1) calculées dans l'itération i-1 et en fonction également d'une condition de détermination du signe d de l'opération basée sur les coordonnées de l'itération i-1. Le calculateur comprend également un moyen de détermination de la valeur angulaire permettant d'obtenir une valeur d'angle numérique pour chaque piste individuelle du disque. Ce moyen de détermination comporte un moyen d'utiliser le signe « d » ainsi déterminée pour ajouter ou soustraire un coefficient $\beta\_i$ dépendant du niveau d'itération à la valeur précédente d'angle Zi-1 pour obtenir la valeur d'angle à connaître Zi.

Chaque itération se base sur des phases de calcul sensiblement identique. La première phase de calcul d'une itération est la détermination du signe « d » en fonction des valeurs Xi et Yi calculées lors de l'itération précédente « i-1 » ou des valeurs X0 et Y0 saisies lors de la première étape réalisée par le procédé, selon l'invention. La détermination du signe « d » est réalisée par un moyen de comparaison des valeurs Xi et Yi calculées lors de l'itération précédente « i-1 » selon des conditions de détermination. Ce moyen de comparaison est compris dans le calculateur. Ainsi en se référant à l'exemple ci-dessus, lors de la première itération, le signe « d » est déterminé par les valeurs X0 et Y0 saisies lors de la première étape, réalisée par le procédé, selon l'invention. Les conditions de détermination de « d » sont: d= 1 si $X_0 < 0$ et $Y_0 < 0$ sinon d= -1. Lors des itérations suivantes, le signe « d » est déterminé en fonction des valeurs Xi-1 et Yi-1 calculées lors des itérations précédentes. Par exemple dans l'itération numéro 2, « d » est défini suivant X1 et Y1. Les conditions de détermination de « d » dans une itération «i» sont : d= 1 si $X_{i-1} < 0$ et $Y_{i-1} < 0$ sinon d= -1.

La deuxième phase de calcul d'une itération « i », consiste à déterminer la valeur Xi en fonction des valeurs Xi-1 et Yi-1 calculées lors des itérations précédentes et en fonction du signe « d » défini lors de la première phase de l'itération numéro i. Lors de cette deuxième phase de calcul, le calculateur utilise un moyen de déterminer l'opération, dans l'exemple une addition, associée au signe précédemment déterminé « d » pour calculer la coordonnée Xi. En se référant à l'exemple ci-dessus, la valeur de X1 est obtenue en fonction des valeurs X0 et Y0 saisies lors de la première étape, réalisée par le procédé, selon l'invention et en fonction du signe « d » défini lors de la première phase de l'itération numéro 1. A partir de l'itération numéro 6, Xi est une valeur proche de zéro. Cette valeur ne varie plus et reste, lors des calculs des itérations suivantes, à la valeur de X5.

La troisième phase de calcul d'une itération « i », consiste à déterminer la valeur Yi en fonction des valeurs Xi-1 et Yi-1 calculées lors des itérations précédentes et du signe « d » défini lors de ia première phase de l'itération numéro « i ». Lors de cette troisième phase de calcul, le calculateur utilise un moyen de déterminer l'opération, dans l'exemple une soustraction, associée au signe précédemment déterminé « d » pour calculer la coordonnée Yi. En se référant à l'exemple ci-dessus, la valeur de Y1 est obtenue en fonction des valeurs X0 et Y0 saisies lors de la première étape, réalisée par le procédé, selon l'invention et en fonction du signe « d » défini lors de la première phase de l'itération numéro « 1 ». La détermination de la valeur Yi et du signe « d » dans les itérations 6 à 13 est réalisée en fonction de la valeur X5 et non la valeur Xi-1.

La dernière phase de calcul d'une itération « i » est réalisée par le moyen de détermination de la valeur angulaire permettant d'obtenir une valeur d'angle numérique pour chaque piste individuelle (2a et 2c). Cette phase consiste à déterminer la valeur Zi en fonction du signe « d » défini lors de la première phase de l'itération numéro « i » et en fonction des constantes prédéfinies α_i et β_i et / ou en fonction de la valeur Zi-1 calculée lors de l'itération « i-1 » précédente. Lors de cette dernière phase de calcul, le calculateur fait appel au moyen d'utiliser le signe « d » de l'opération pour ajouter ou soustraire un coefficient β_i dépendant du niveau d'itération à la valeur d'angle Zi-1 pour obtenir une nouvelle valeur d'angle Zi. En se référant à l'exemple ci-dessus, la valeur de Z1 est obtenue en fonction des constantes prédéfinis α_i et β_i et en fonction du signe « d » défini lors de la première phase de l'itération numéro « 1 ». La valeur de Z2 est obtenue en fonction des constantes prédéfinies, en fonction de la valeur de Z1 et en fonction du signe « d » défini lors de la première phase de l'itération numéro 2. Lors de la dernière itération, la valeur de Z est représentative de l'angle de positionnement, par exemple, d'un bras mécanique en rotation autour d'un axe. Les valeurs $\gamma$_i, α_i et β_i présentes dans l'exemple ci-dessus, sont des constantes prédéfinies par un programmateur et leurs valeurs sont distinctes à chaque itération. Ces constantes sont calculées suivant la précision de l'erreur de calcul que l'on veut obtenir et en fonction du nombre d'itérations à réaliser. L'erreur de précision obtenue par le calcul, avec une telle méthode, est inférieure à $1.5e^n$, sachant que $e = 2^{-b}$, b étant le nombre de bits utilisés pour représenter un nombre, et n étant égal au nombre d'itérations. Les constantes sont également déterminées en fonction d'un coefficient « a » qui réalise le calcul principal de détermination de l'angle. Le calcul de ce coefficient est le suivant : $a_{itération} = \tan^{-1}(2^{-itération})$. Les constantes $\gamma$_i, α_i et β_i, et le nombre d'itérations prédéfini, permettent de minimiser le temps du calcul de l'interpolation et le nombre de portes logiques dont les signaux sont utilisés par le calculateur du codeur optique. Une autre astuce de ce procédé, pour minimiser le nombre de portes, est de se baser à partir d'une itération « k » sur des valeurs X, Y et Z entières. En effet, les chiffres situés après la virgule ne sont pas significatifs pour la précision de l'angle. Ainsi plus il y a de chiffres derrière la virgule, plus il y a de portes dans le calculateur.

Ce calcul d'interpolation angulaire permet d'obtenir la valeur d'un calcul sur une période allant de -90° à 90°, sachant que, pour une valeur de sortie 0, l'angle correspondant est -90°.

La troisième étape du procédé, selon l'invention, concerne la détermination de la valeur angulaire calculée sur une période angulaire de 360°. Le calcul réalisé lors de l'étape 2 n'est défini que sur une période angulaire de 180°, allant de -90° à 90°. L'objectif de la troisième étape est de déterminer la zone de 180° du disque, sur laquelle est défini l'angle. Pour obtenir ce résultat sur 360°, le procédé va se baser sur la valeur du bit de poids fort du mot binaire généré lors de la conversion analogique numérique des signaux sinusoïdaux sinus et cosinus. Ce bit permet de définir la zone de 180°, en fonction des valeurs 1 ou 0. Par exemple l'axe se situe entre -90° et 90°, en se déplaçant dans le sens trigonométrique, la valeur du bit de poids fort est de 1, à l'inverse la valeur, du bit de poids fort, est de 0.

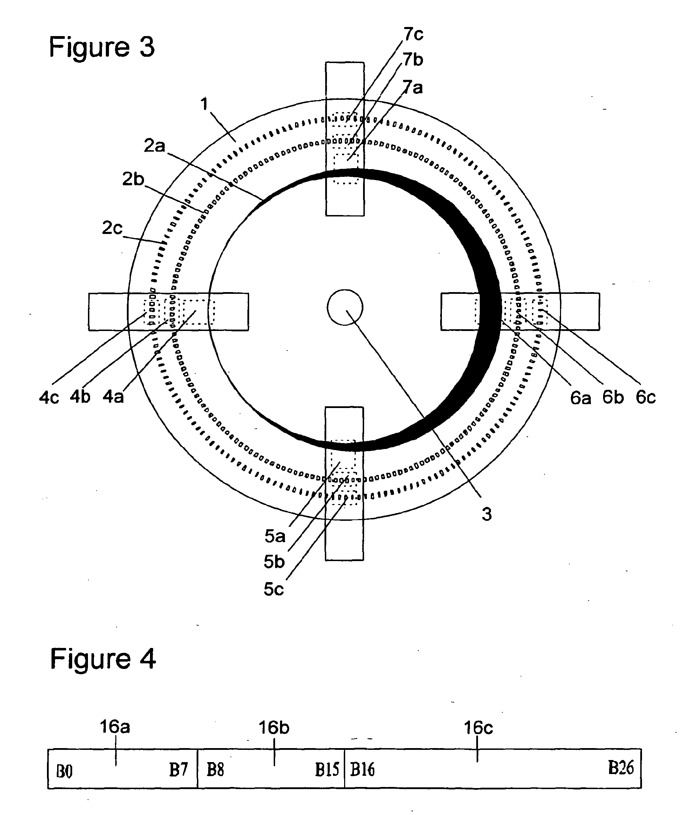

L'objet de la découverte est de mettre à disposition un codage angulaire, donnant une position angulaire absolue avec une grande résolution et une grande précision. Afin d'obtenir un résultat angulaire précis, des pistes intermédiaires sont disposées sur le disque proche de la piste fine du codeur optique, présenté sur la figure 3. L'objectif de la présente invention est de réaliser un codeur optique haute résolution utilisant le principe de calcul d'interpolation angulaire précédemment présenté, sur les pistes internes disposées sur le disque proche de la piste fine. Le dispositif représentatif du codeur optique haute résolution permet ainsi, de diminuer le nombre de photodétecteurs généralement utilisés dans les phases de levée de doute, pour obtenir une meilleure précision. L'interpolation effectuée sur ces pistes va enrichir le mot binaire définissant avec précision la position angulaire du disque. On obtient ainsi un résultat précis tout en diminuant le nombre de photodétecteurs compris dans le codeur.

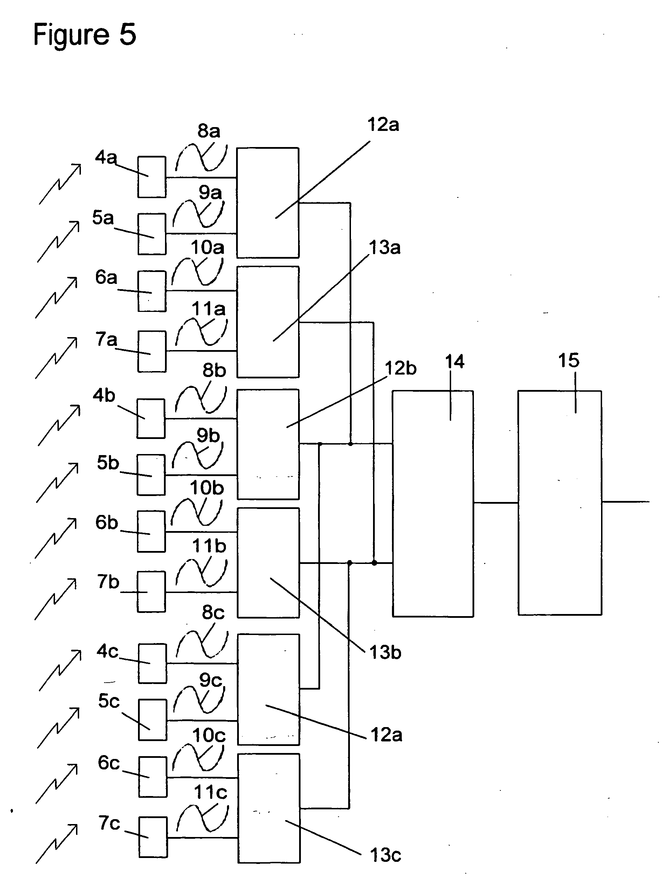

Le dispositif du codeur optique haute résolution, selon l'invention, comprend un disque comportant plusieurs pistes, dont au moins une piste fine et une piste, dite piste interne. Dans un mode de résolution de l'invention représenté par la figure 3, le dispositif, comprend un disque comportant lui-même, au moins, une piste fine et deux pistes internes. Le partage en division opaque et transparente, de chaque piste, fine et internes, représente le multiple entier de la précédente piste. La précision et la linéarité du signal généré par la lecture des pistes individuelles et le rapport de division des pistes suivantes sont déterminées de façon à ce que la valeur angulaire d'une piste soit synchronisée sans équivoque par la période du signal de la piste précédente. En référence aux figures 3 et 5, une première piste interne (2a), dite piste à 360°, est située au centre du disque (1). Cette piste (2a) est de division grossière, elle permet de fournir au moins un signal sinusoïdal avec seulement une période par tour du disque codé. La piste interne (2a) peut être de forme progressive. C'est l'épaisseur de la piste qui varie. La forme progressive du tracé de la piste va fournir par sa lecture, la fonction sinus ou cosinus du signal. Concentriquement à l'extérieure de cette piste, est disposée une deuxième piste interne intermédiaire (2b). Cette piste est de division plus fine que la première piste interne. Elle permet, par exemple d'obtenir au moins 64 périodes d'un signal sinusoïdal par tour du disque codé (1). La piste intermédiaire est composée de graduations opaques et transparentes de division plus fine par rapport à la première piste interne. Enfin, concentriquement à l'extérieure de cette piste intermédiaire (2b), est disposée une piste fine (2c). La piste fine (2c) est la piste incrémentale qui représente la résolution la plus fine souhaitée de la division angulaire. La piste fine (2c) est également constituée de graduations opaques alternant avec des zones transparentes. Chaque piste est lue par quatre photodétecteurs (4, 5, 6 et 7) disposés de telle sorte qu'ils sont décalés de 90° les uns des autres. On obtient ainsi, pour chaque piste quatre signaux sinusoïdaux (8, 9, 10 et 11) déphasés de 90°, représentant respectivement un signal sinus (8a, 8b et 8c), un signal sinus inversé (9a, 9b et 9c), un signal cosinus (10a, 10b et 10c) et un signal cosinus inversé (11a, 11 b et 11 c). Ces signaux sont ensuite entrés dans des amplificateurs différentiels (12 et 13) afin d'obtenir un signal sinus et un signal cosinus sans la part du courant continu. Ces deux signaux sont ensuite numérisés dans un moyen de numérisation multiplexé (14), par exemple un convertisseur numérique analogique. Enfin, les signaux sinus et cosinus numérisés entrent dans le calculateur (15) pour réaliser l'interpolation angulaire. Les signaux résultant de chaque piste sont ainsi traités. Le système d'exploitation de l'invention comprend un moyen de conversion numérique analogique multiplexé et un calculateur utilisant le multiplexage de données afin d'effectuer l'interpolation angulaire dynamique sur les signaux résultant de la lecture de chaque piste en utilisant le même procédé dynamique d'interpolation angulaire.

Le résultat généré par le codeur optique haute résolution est représenté dans un mot binaire. Ce mot binaire a la particularité de se décomposer en autant de parties qu'il y a de pistes disposées sur le disque codé. Dans le mode de réalisation cité de la présente invention, le mot binaire se décompose en trois parties. La figure 4 montre un exemple représentatif d'un mot binaire résultant de la présente invention. En référence à cette figure, on peut exprimer de manière simplifiée la composition du mot binaire. Les bits B15 à B25 résultent de la lecture de la piste fine, les bits B8 à B14 résultent de la lecture de la piste intermédiaire et les bits B0 à B7 résultent de la lecture de la piste la moins fine. La détermination (définition) du mot binaire est réalisée de manière plus complexe permettant de synchroniser les résultats de la lecture des pistes.

Ainsi les premiers bits du mot binaire, dits bits de poids faible (B16 à B25), sont obtenus par le procédé d'interpolation angulaire sur les signaux sinus et cosinus résultant de la lecture de la piste fine. Le bit B15 est une transcription de la lecture de la piste fine. L'organigramme représentatif de ce bit correspond à un signal en créneau représentant les zones opaques et transparentes de la piste fine.

Les bits intermédiaires (B8 à B14), dits bits intermédiaires de poids forts, sont obtenus par le biais de deux traitements effectué par le calculateur du codeur optique. Le premier traitement consiste à obtenir un premier mot binaire. Le premier bit de ce mot binaire est une transcription de la lecture de la piste intermédiaire. L'organigramme représentatif de ce bit correspond à un signal en créneau représentant les zones opaques et transparentes de la piste intermédiaire. Les autres bits de ce premier mot binaire sont obtenus par le procédé d'interpolation angulaire réalisé à l'aide des signaux sinusoïdaux résultant de la lecture de la piste intermédiaire. Le deuxième traitement permet de synchroniser le résultat du premier mot binaire avec le bit B15 obtenu par lecture de la piste fine. Ce traitement combinatoire réalisé par le calculateur du codeur optique permet d'obtenir les bits B8 à B14.

Les derniers bits (B0 à B7), dits bits de poids forts, sont également obtenus par le biais de deux traitements effectué par le calculateur du codeur optique. Le premier traitement consiste à obtenir un premier mot binaire. Le premier bit de ce mot binaire est une transcription de la lecture de la piste. L'organigramme représentatif de ce bit correspond à un signal en créneau représentant les zones opaques et transparentes de la dernière piste. Les autres bits de ce premier mot binaire sont obtenus par le procédé d'interpolation angulaire réalisé à l'aide des signaux sinusoïdaux résultant de la lecture de la dernière piste. Le deuxième traitement permet de synchroniser le résultat du premier mot binaire avec le bit B8 obtenu par lecture de la piste intermédiaire. Ce traitement combinatoire réalisé par le calculateur du codeur optique permet d'obtenir les bits B0 à B7.

Dans le système d'exploitation, le mot binaire comprend les valeurs numériques générées par la lecture de chaque piste individuelle, et représente la position angulaire absolue par exemple d'un bras mécanique en rotation autour d'un axe. Ce mot binaire est défini par le biais du multiplexage des données lors du calcul de l'interpolation angulaire fait par le calculateur (15). Ce multiplexage permet d'obtenir chaque résultat de la lecture des pistes individuelles, en utilisant le même calcul dynamique d'interpolation angulaire.

Comme la linéarité de l'interpolation des signaux sinus et cosinus des pistes individuelles doit être très précise pour que chaque valeur angulaire soit classée dans une demi-période de la piste précédente plus fine, il faut que la position angulaire absolue soit déterminée sans ambiguïté. Ainsi la première piste interne (2a) permet d'obtenir une première précision grossière, permettant de déterminer la zone de 180° où se trouve le bras mécanique. La piste fine (2b) permet une meilleure précision sur la valeur de l'angle formé par le bras mécanique en rotation autour d'un axe.

Le mode de réalisation présenté précédemment est un exemple de réalisation non limitatif d'un codeur optique selon l'invention. Un codeur optique peut comprendre sur son disque codé un nombre quelconque de pistes internes. La composition du mot binaire est définie suivant le nombre de pistes disposées sur le disque. Le nombre de bits représentatifs de la lecture d'une piste individuelle, dans le mot binaire, peut être de valeur quelconque.

Il doit être évident pour les personnes versées dans l'art que la présente invention permet des modes de réalisation sous de nombreuses autres formes spécifiques sans l'éloigner du domaine d'application de l'invention comme revendiqué. Par conséquent, les présents modes de réalisation doivent être considérés à titre d'illustration, mais peuvent être modifiés dans le domaine défini par la portée des revendications jointes, et l'invention ne doit pas être limitée aux détails donnés ci-dessus.

**Revendications**

1. Procédé d'interpolation angulaire, effectué par un codeur optique, ledit codeur optique comprenant au moins, un disque (1) comportant au moins une piste circulaire (2) formée par des zones alternativement opaques et transparentes, une source lumineuse éclairant la piste, des capteurs permettant de convertir un signal optique généré par la source lumineuse et le disque en un signal analogique, un moyen de convertir un signal analogique en un signal numérique (14) et un calculateur (15) réalisant le traitement des données, le procédé d'interpolation angulaire est **caractérisé en ce qu'**il comprend les étapes suivantes :

   - la lecture et la saisie des valeurs numériques $X_0$ et $Y_0$ des signaux générés par la source lumineuse et la piste circulaire, les signaux analogiques étant numérisés par un moyen de convertir un signal analogique en un signal numérique,
   - le calcul dynamique de l'interpolation angulaire réalisé sur une période angulaire allant de -90° à 90°, ledit calcul d'interpolation angulaire étant sensiblement équivalent à un calcul par itération, avec chaque itération « i » comprenant, la détermination d'un signe « d » en fonction de valeurs $X_{i-1}$ et $Y_{i-1}$ précédemment calculées ou lues dans l'itération « i-1 » précédente, le calcul de nouvelles valeurs Xi et Yi permettant de déterminer le signe « d » à utiliser dans la prochaine itération « i+1 », et le calcul d'une valeur $Z_i$ s'approchant, à chaque itération, de la valeur finale de l'angle à connaître.
   - la détermination de la zone de 180° situant la position de l'angle, permettant d'obtenir un résultat sur une période angulaire de 360°, ledit résultat étant présenté par un mot binaire comprenant un nombre de bits prédéfinis.

2. Procédé d'interpolation angulaire selon la revendication 1, **caractérisé en ce qu'**il effectue la saisie de données numériques $Y_0$ et $X_0$ lors de la première étape du calcul d'interpolation angulaire, lesdites données numériques résultant de la lecture de signaux sensiblement identiques à des signaux sinusoïdaux respectivement de type sinus et cosinus.

3. Procédé d'interpolation angulaire selon la revendication 1 ou 2, **caractérisé en ce que** la valeur $X_i$ de l'itération « i », « i » étant différente de la valeur nulle, est calculée en fonction des valeurs $X_{i-1}$ et $Y_{i-1}$ calculées lors de l'itération « i -1 » précédente, et en fonction du signe « d », déterminé lors de l'itération « i ».

4. Procédé d'interpolation angulaire selon une des revendications 1 à 3, **caractérisé en ce que** la valeur $Y_i$ de l'itération « i », « i » étant différente de la valeur nulle, est calculée en fonction des valeurs $X_{i-1}$ et $Y_{i-1}$ calculées lors de l'itération « i-1 » précédente, et en fonction du signe « d » déterminé lors de l'itération « i ».

5. Procédé d'interpolation angulaire selon une des revendications 1 à 4, **caractérisé en ce que** le signe « d » est déterminé lors de l'étape de saisie des données, par un moyen de comparaison de la valeur des données numérique $Y_0$ et $X_0$ , en fonction des conditions suivantes : d = 1 si $X_0 < 0$ et $Y_0 < 0$ sinon d = -1.

6. Procédé d'interpolation angulaire selon une des revendications 1 à 5, **caractérisé en ce que** le signe « d » est déterminé lors des itérations « i », « i » étant différente de la valeur nulle, par un moyen de comparaison de la valeur des données $X_{i-1}$ et $Y_{i-1}$ déterminées dans l'itération précédente « i-1 *»,* en fonction des conditions suivantes : d = 1 si $X_{i-1} < 0$ et $Y_{i-1} < 0$ sinon d = -1.

7. Procédé d'interpolation angulaire selon une des revendications 1 à 6, **caractérisé en ce que** la valeur $Z_i$ de l'itération « i », « i » étant différente de la valeur nulle, est calculée en fonction du signe « d » déterminé dans l'itération « i » et soit, d'une constante prédéfinie ou soit, de la valeur $Z_{i-1}$ calculée lors de l'itération « i-1 » précédente.

8. Procédé d'interpolation angulaire selon une des revendications 1 à 7, **caractérisé en ce que** le nombre d'itérations est prédéfini, permettant ainsi de prédéfinir les constantes utilisées dans le calcul et ainsi de diminuer le temps de calcul d'interpolation réalisé par le calculateur (15), et de diminuer le nombre de portes logiques dont les signaux sont utilisés par le calculateur (15) du codeur optique, tout en obtenant un résultat précis.

9. Procédé d'interpolation angulaire selon une des revendications 1 à 8, **caractérisé en ce que** la valeur X ne varie plus et n'est plus calculée dès lors, qu'elle est égale à une valeur proche de zéro, ladite valeur X restant la même dans les itérations suivantes.

10. Procédé d'interpolation angulaire selon une des revendications 1 à 9, **caractérisé en ce qu'**il calcule les valeurs X, Y et Z pour obtenir des valeurs entières, les valeurs en décimales n'étant pas significatives pour la précision de l'angle, ledit calcul en valeur entière permettant de diminuer le nombre de portes logiques dont les signaux sont utilisés par le calculateur du codeur optique.

11. Procédé d'interpolation angulaire selon une des revendications 1 à 10, **caractérisé en ce que** l'erreur de calcul, obtenue avec un tel procédé d'interpolation angulaire, est inférieure à 1.5en, sachant que $e = 2^{-b}$, b étant le nombre de bits utilisés pour représenter un nombre, et n étant égal au nombre d'itérations prédéfinies.

12. Procédé d'interpolation angulaire selon une des revendications 1 à 11 **caractérisé en ce que** la zone de 180° situant la position de l'angle, est déterminée par le bit de poids fort d'un mot binaire obtenu par la conversion analogique numérique d'un signal sinusoïdal de type sinus ou cosinus résultant de la lecture de la piste, ladite conversion étant réalisée par le moyen de convertir un signal analogique en un signal numérique (14).

13. Codeur optique de haute résolution comprenant :

   - un disque (1) comportant au moins deux pistes (2a et 2c), dont une piste de division fine (2c) et une piste de division plus grossière (2a), le partage en division de chaque piste étant un multiple de la piste précédente,
   - quatre photodétecteurs (4, 5, 6 et 7) pour lire chacune desdites pistes (2a et 2c) et permettre d'obtenir par piste des signaux sensiblement sinusoïdaux décalés de 90° chacun,
   - un moyen de convertir un signal analogique en un signal numérique (14) pour numériser les signaux obtenus et définir des coordonnées initiales d'angle de positions (X0 et Y0),

   le codeur optique haute résolution étant **caractérisé en ce qu'**il comporte un calculateur pour effectuer un calcul dynamique d'interpolation angulaire à partir des signaux sinusoïdaux générés via la lecture par les quatre photo-détecteurs (4, 5, 6 et 7) de chaque piste individuelle (2a et 2c) et convertis en signaux numériques, le calculateur (15) étant agencé pour produire une valeur d'angle numérique pour chaque piste individuelle (2a et 2c)et comprenant des moyens d'itération pour réaliser ledit calcul sur une période angulaire allant de -90° à 90°, les moyens d'itération étant aptes, pour chaque itération « i », à :

   - déterminer un signe « d » en fonction de valeurs numériques $X_{i-1}$ et $Y_{i-1}$ précédemment calculées ou lues dans l'itération « i-1» précédente,
   - calculer de nouvelles valeurs numériques Xi et Yi permettant de déterminer le signe « d » à utiliser dans la prochaine itération « i+1 », et
   - calculer une valeur $Z_i$ s'approchant, à chaque itération, de la valeur finale de l'angle à connaître. le codeur optique incluant des moyens pour déterminer la zone de 180° situant la position de l'angle et générer un mot numérique représentant la position angulaire absolue du disque.

14. Codeur optique de haute résolution selon la revendication 13, **caractérisé en ce que** les moyens d'itération du calculateur comportent un moyen de déterminer dans une itération i l'opération, addition ou soustraction, de la coordonnée orthogonale (Xi ou Yi) à celle (Yi-1 ou Xi-1) calculée dans l'itération précédente i-1, cette opération étant associée à une condition de détermination d'un signe (d) obtenue par un moyen de comparaison des coordonnées de l'itération précédente avec une valeur constante et des moyens d'utiliser le signe (d) de l'opération ainsi déterminée pour ajouter ou soustraire un coefficient (β_i) dépendant du niveau d'itération à la valeur précédente d'angle (Zi-1) pour obtenir une valeur d'angle à connaître (Zi).

**15.** Codeur optique de haute résolution selon la revendication 13 ou 14, **caractérisé en ce que** le traitement des signaux numériques de forme sensiblement sinusoïdale arrivant dans le calculateur (15); fournit un mot binaire correspondant à la lecture d'une piste, ledit mot binaire comprenant un premier bit représentatif de la variation des zones opaques et transparentes de la piste lue et les autres bits restants étant représentatifs de la valeur d'angle numérique fournie par un calcul dynamique d'interpolation angulaire.

**16.** Codeur optique de haute résolution selon une des revendications 13 à 15, **caractérisé en ce que** les mots binaires résultant du traitement des signaux numériques générés lors de la lecture de chaque piste individuelle sont traités de manière combinatoire les uns aux autres, permettant d'obtenir un mot binaire final synchronisé, représentatif de la position angulaire absolue du disque, ledit mot binaire final étant constitué de telle sorte que les bits de poids faibles (16c) correspondent à la valeur angulaire représentative de la lecture de la piste de division la plus fine (2c) et les bits de poids fort (16a) correspondent à la valeur angulaire représentative de la lecture de la piste de division la moins fine (2a).

**17.** Codeur optique de haute résolution, selon une des revendications 13 à 16, **caractérisé en ce qu'**il comprend un moyen de convertir un signal analogique en un signal numérique (14) multiplexé permettant de numériser les signaux de forme sensiblement sinusoïdale, générés par la lecture de chaque piste individuelle en fonction du multiplexage commandé par le calculateur.

**18.** Codeur optique de haute résolution, selon une des revendications 13 à 17, **caractérisé en ce qu'**il comprend un système de traitement de données multiplexé, permettant de réaliser le même procédé dynamique d'interpolation angulaire à partir de tous les signaux sinusoïdaux générés par la lecture de chaque piste individuelle.

**19.** Codeur optique de haute résolution selon une des revendications 13 à 18, comprenant un disque pouvant comporter plus de deux pistes, les pistes étant de division différente plus ou moins fine, et étant disposées les unes par rapport aux autres de manière concentrique sur le disque, permettant que le partage en division de chaque piste soit un multiple de la piste précédente.

**20.** Codeur optique de haute résolution selon une des revendications 13 à 19, défini en ce que la piste de division la moins fine (16a) permet de générer lors de sa lecture, au moins un signal de forme sensiblement sinusoïdale dont la période correspond à un tour de rotation du disque codé.

**21.** Codeur optique de haute résolution selon une des revendications 13 à 20, défini en ce que la partie opaque de la piste de division la moins fine (16a) a une épaisseur dans le sens radial variant selon une loi déterminée et permettant de générer par sa lecture un signal de forme sensiblement sinusoïdale.

**Claims**

**1.** Angular interpolation method, carried out by an optical encoder, said optical encoder comprising at least, a disc (1) comprising at least one circular track (2) formed by zones that are alternately opaque and transparent, a light source lighting the track, sensors enabling an optical signal generated by the light source and the disc to be converted to an analogue signal, a means for converting an analogue signal to a digital signal (14) and a computer (15) performing the data processing, the angular interpolation method being **characterised in that** it comprises the following steps:

- the reading and inputting of digital values $X_0$ and $Y_0$ of the signals generated by the light source and the circular track, the analogue signals being digitised by a means for converting an analogue signal to a digital signal;
- the dynamic angular interpolation calculation performed over one angular period from -90° to 90°, said angular interpolation calculation being substantially equivalent to a calculation by iteration, with each iteration "i" comprising the determination of a sign "d" as a function of values $X_{i-1}$ and $Y_{i-1}$ calculated previously or read in the previous iteration "i-1", the calculation of new values Xi and Yi enabling the sign "d" to be determined for use in the next iteration "i+1", and the calculation of a value $Z_i$ value approaching, upon each iteration, the final value of the angle to be known;
- the determination of the 180° zone covering the position of the angle, enabling a result over one angular period of 360° to be obtained, said result being presented by a binary word comprising a number of predefined bits.

**2.** Angular interpolation method according to Claim 1, **characterised in that** it effects the inputting of digital data $Y_0$ and $X_0$ during the first step of the angular interpolation calculation, said digital data resulting from the reading of signals that are substantially identical to sinusoidal signals of the sine and cosine type respectively.

3. Angular interpolation method according to Claim 1 or 2, **characterised in that** the value $X_i$ of the iteration *"i"*, where *"i"* is different from zero, is calculated as a function of the values $X_{i-1}$ and $Y_{i-1}$ calculated during the previous iteration "i-1 ", and as a function of the sign "d" determined during the iteration "i".

4. Angular interpolation method according to any one of Claims 1 to 3, **characterised in that** the value $Y_i$ of the iteration "i", where "i" is different from zero, is calculated as a function of the values $X_{i-1}$ and $Y_{i-1}$ calculated during the previous iteration "i-1", and as a function of the sign "d" determined during the iteration "i".

5. Angular interpolation method according to any one of Claims 1 to 4, **characterised in that** the sign "d" is determined during the data input step by a means for comparing the value of the digital data $Y_0$ and $X_0$, according to the following conditions: d = 1 if $X_0$ < 0 and $Y_0$ < 0, else d = -1.

6. Angular interpolation method according to any one of Claims 1 to 5, **characterised in that** the sign "d" is determined during the iterations "i", where "i" is different from zero, by a means for comparing the values of the data $X_{i-1}$ and $Y_{i-1}$ determined in the previous iteration "i-1", as a function of the following conditions: d = 1 if $X_{i-1}$ < 0 and $Y_{i-1}$ < 0, else d = -1.

7. Angular interpolation method according to any one of Claims 1 to 6, **characterised in that** the value $Z_i$ of the iteration "i", where "i" is different from zero, is calculated as a function of the sign "d" determined in the iteration "i" and as a function of either a predefined constant, or the value $Z_{i-1}$ calculated during the previous iteration "i-1".

8. Angular interpolation method according to any one of Claims 1 to 7, **characterised in that** the number of iterations is predefined, thus enabling the constants used in the calculation to be predefined and thus the time of the interpolation calculation executed by the computer (15) to be reduced, and the number of logic gates the signals of which are used by the computer (15) of the optical encoder to be reduced, while still obtaining an accurate result.

9. Angular interpolation method according to any one of Claims 1 to 8, **characterised in that** the value X no longer changes and is no longer calculated from the moment it is equal to a value close to zero, said value X remaining the same in the subsequent iterations.

10. Angular interpolation method according to any one of Claims 1 to 9, **characterised in that** it calculates the values X, Y and Z to obtain integer values, the decimal values not being of significance for the precision of the angle, said integer value calculation enabling the number of logic gates the signals of which are used by the computer of the optical encoder to be reduced.

11. Angular interpolation method according to any one of Claims 1 to 10, **characterised in that** the calculation error obtained with such an angular interpolation method is less than 1.5en, where $e = 2^{-b}$, where b is the number of bits used to represent a number and n is equal to the number of predefined iterations.

12. Angular interpolation method according to any one of Claims 1 to 11, **characterised in that** the 180° zone covering the position of the angle, is determined by the most significant bit of a binary word obtained by the analogue-to-digital conversion of a sine or cosine type sinusoidal signal resulting from the reading of the track, said conversion being carried out by the means for converting an analogue signal to a digital signal (14).

13. High resolution optical encoder comprising:

- a disc (1) comprising at least two tracks (2a and 2c), of which one is a fine division track (2c) and one a coarser division track (2a), the dividing-up of each track into divisions being a multiple of the previous track,
- four photodetectors (4, 5, 6 and 7) to read each of said tracks (2a and 2c) and to enable, for each track, substantially sinusoidal signals, each shifted by 90°, to be obtained,
- a means for converting an analogue signal to a digital signal (14) to digitise the signals obtained and to define initial angle position co-ordinates (X0 and Y0), the high resolution optical encoder being **characterised in that** it comprises a computer to execute a dynamic angular interpolation calculation from the sinusoidal signals generated via the reading by the four photodetectors (4, 5, 6 and 7) of each individual track (2a and 2c) and converted to digital signals, the computer (15) being set up to produce a digital angle value for each individual track (2a and 2c) and comprising iteration means for performing said calculation over one angular period from -90° to 90°, the iteration means being intended, for each iteration "i":

- to determine a sign "d" as a function of the digital values $X_{i-1}$ and $Y_{i-1}$ calculated previously or read in the previous iteration "i-1 ",
- to calculate new digital values Xi and Yi for determining the sign "d" to be used in the next iteration "i+1 ", and
- to calculate a value $Z_i$ approaching, upon each iteration, the final value of the angle to be known,

the optical encoder including means for determining the 180° zone covering the position of the angle and generating a digital word representing the absolute angular position of the disc.

**14.** High resolution optical encoder according to Claim 13, **characterised in that** the iteration means of the computer comprise a means for determining in an iteration i the operation, addition or subtraction, of the co-ordinate (Xi or Yi) orthogonal to the co-ordinate (Yi-1 or Xi-1) calculated in the previous iteration i-1, this operation being associated with a condition of determination of a sign (d) obtained by a means for comparing co-ordinates from the previous iteration with a constant value and means for using the sign (d) of the operation thus determined to add or subtract a coefficient (β_i) dependent on the iteration level at the previous angle value (Zi-1) to obtain an angle value to be known (Zi).

**15.** High resolution optical encoder according to Claim 13 or 14, **characterised in that** the processing of the digital signals of substantially sinusoidal shape arriving in the computer (15) provides a binary word corresponding to the reading of a track, said binary word comprising a first bit representing the variation of the opaque and transparent zones of the track read and the other remaining bits representing the digital angle value provided by a dynamic angular interpolation calculation.

**16.** High resolution optical encoder according to any one of Claims 13 to 15, **characterised in that** the binary words resulting from the processing of the digital signals generated during the reading of each individual track are processed in a combinatorial manner with one another, enabling a synchronised final binary word to be obtained, representative of the absolute angular position of the disc, said final binary word being formed such that the least significant bits (16c) correspond to the angular value representing the reading of the finest division track (2c) and the most significant bits (16a) correspond to the angular value representative of the reading of the least fine division track (2a).

**17.** High resolution optical encoder according to any one of Claims 13 to 16, **characterised in that** it comprises a means for converting an analogue signal to a multiplexed digital signal (14) enabling the substantially sinusoidal shaped signals, generated by the reading of each individual track to be digitised as a function of the multiplexing controlled by the computer.

**18.** High resolution optical encoder according to any one of Claims 13 to 17, **characterised in that** it comprises a multiplexed data processing system enabling the same dynamic angular interpolation method to be executed from all the sinusoidal signals generated by the reading of each individual track.

**19.** High resolution optical encoder according to any one of Claims 13 to 18, comprising a disc able to have more than two tracks, the tracks being of different division, more fine or less fine, and being arranged one with respect to the other concentrically on the disc, enabling the dividing-up of each track into divisions to be a multiple of the previous track.

**20.** High resolution optical encoder according to any one of Claims 13 to 19, defined in that the least fine division track (16a), when it is being read, enables the generation of at least one signal of substantially sinusoidal shape, the period of which corresponds to one rotational turn of the encoded disc.

**21.** High resolution optical encoder according to any one of Claims 13 to 20, defined in that the opaque part of the least fine division track (16a) has a thickness in the radial direction varying according to a determined law and, when it is read, enabling a signal of substantially sinusoidal shape to be generated.

**Patentansprüche**

**1.** Winkelinterpolationsverfahren mittels einer optischen Codiervorrichtung,
umfassend mindestens eine Scheibe (1) mit mindestens einer kreisförmigen Bahn (2) aus abwechselnd angeordnete lichtundurchlässigen und transparenten Bereichen, sowie einer die Bahn bestrahlenden Lichtquelle, einem Sensor zur Umwandlung eines von der Lichtquelle und der Scheibe erzeugten optischen Signals in ein analoges Signal, einer Einrichtung zur Umwandlung eines analogen Signals in ein digitales Signal (14) und einem die Daten bearbeitenden Rechner (15), **gekennzeichnet durch** folgende Schritte:

Lesen und Erstellen der digitalen Werte $X_0$ und $Y_0$ aus den **durch** die Lichtquelle und der kreisförmigen Bahn erzeugten Signalen, wobei die analogen Signale **durch** die Einrichtung zur Umwandlung eines analogen Signals in ein digitales Signal digitalisiert werden,

dynamische Berechnung der Winkelinterpolation auf einem sich von -90 ° bis 90 ° erstreckenden Winkelumfang, wobei die Berechnung der Winkelinterpolation einer Näherungsberechnung gleicht, bei der mit jedem Näherungsschritt "i" ein Zeichen "d" als Funktion der vorher berechneten und gelesenen Werte $X_{i-1}$ und $Y_{i-1}$ der vorher berechneten Näherung "i-1" bestimmt wird, und Berechnung neuer Werte $X_i$ und $Y_i$, die die Bestimmung des Zeichens "d" ermöglichen, das in der nächstfolgenden Näherung "i+1" verwendet wird, und Berechnung eines Wertes Z, der sich mit jeder Näherung dem gesuchten Endwert des Winkels nähert, und

Bestimmung des der Winkelstellung zugeordneten 180° Bereichs, der ein Ergebnis über einen Winkelumfang von 360° ermöglicht, das **durch** ein Byte mit eine Anzahl vorbestimmter Bits dargestellt wird.

2. Winkelinterpolationsverfahren nach des Anspruchs 1, **dadurch gekennzeichnet, dass** die Erstellung der digitale Werte $X_0$ und $Y_0$ im ersten Berechnungsschritt der Winkelinterpolation, durch Ablesen nahezu identischer Sinus-Signale bzw. Kosinus-Signale erfolgt.

3. Winkelinterpolationsverfahren nach Anspruch 1 oder 2 **dadurch gekennzeichnet, dass** der Wert $X_i$ der Annäherung "i" , wobei sich "i" vom Wert Null unterscheidet, als Funktion der Werte $X_{i-1}$ und $Y_{i-1}$, die aus der vorausgehenden Annäherung "i-1" errechnet wurden, und als Funktion des Zeichens "d", das aus der Annäherung "i" bestimmt wurde, berechnet wird.

4. Winkelinterpolationsverfahren nach einem der Ansprüche 1 bis 3, **dadurch gekennzeichnet, dass** der Wert $Y_i$ der Annäherung "i", wobei sich "i" vom Wert Null unterscheidet, als Funktion der Werte $X_{i-1}$ und $Y_{i-1}$, die aus der vorausgehenden Annäherung "i-1" errechnet wurden, und als Funktion des Zeichens "d", das aus der Annäherung "i" bestimmt wurde, berechnet wird.

5. Winkelinterpolationsverfahren nach einem der Ansprüche 1 bis 4, **dadurch gekennzeichnet, dass** das Zeichen "d" bei der Werteerfassung durch einen Wertevergleich der digitalen Werte $Y_0$ und $X_0$ als Funktion der folgenden Bedingungen erfolgt: d = 1, wenn $X_0 < 0$ und $Y_0 < 0$ ist, andernfalls ist d = -1.

6. Winkelinterpolationsverfahren nach einem der Ansprüche 1 bis 5, **dadurch gekennzeichnet, dass** die Bestimmung des Zeichens "d" aus der Annäherung "i", wobei "i" sich vom Wert Null unterscheidet, durch einen Wertevergleich der Werte $X_{i-1}$ und $Y_{i-1}$, die aus der vorausgehenden Annäherung "i-1" berechnet wurden, als Funktion der folgenden Bedingungen erfolgt: d = 1, wenn $X_{i-1} < 0$ und $Y_{i-1} < 0$ ist, andernfalls ist d = -1.

7. Winkelinterpolationsverfahren nach einem der Ansprüche 1 bis 6, **dadurch gekennzeichnet, dass** der Wert Z aus der Annäherung "i", wobei "i" sich vom Wert Null unterscheidet, als Funktion des in der Annäherung "i" bestimmten Zeichens "d" und einer bestimmten Konstante oder als Wert $Z_{i-1}$ aus der vorausgehenden Annäherung "i-1" berechnet wird.

8. Winkelinterpolationsverfahren nach einem der Ansprüche 1 bis 7, **dadurch gekennzeichnet, dass** die Anzahl der Annäherungen vorbestimmt ist, um so die Anzahl der in der Berechnung verwendeten Konstanten zu bestimmen, um so bei genauen Ergebnissen die Berechnungszeit der Interpolation mittels des Rechners (15) zu verkürzen und die Anzahl der logischen Bauteile zu verringern, deren Signale vom Rechner (15) der optischen Codiervorrichtung benutzt werden.

9. Winkelinterpolationsverfahren nach einem der Ansprüche 1 bis 8, **dadurch gekennzeichnet, dass** der Wert X nicht mehr variiert und von dem Zeitpunkt an nicht mehr berechnet wird, wenn er sich dem Wert Null nähert, wobei der Wert X in den nachfolgenden Annäherungen gleich bleibt.

10. Winkelinterpolationsverfahren nach einem der Ansprüche 1 bis 9, **dadurch gekennzeichnet, dass** zur Berechnung der Werte X, Y und Z als ganze Werte, da die Dezimalwerte für die Winkelgenauigkeit nicht bedeutsam sind, die genannte Berechnung der ganzen Werte eine Verminderung der Anzahl der logischen Bauteile, deren Signale vom Rechner der optischen Codiervorrichtung verwendet werden, ermöglicht.

11. Winkelinterpolationsverfahren nach einem der Ansprüche 1 bis 10, **dadurch gekennzeichnet, dass** der mit dem Winkelinterpolationsverfahren erhaltene Rechenfehlerfaktor unterhalb 1,5 n liegt, da $e = 2^{-b}$, wobei b die Bitanzahl darstellt, die zu einer Zahlendarstellung benötigt wird, und n die Anzahl der vorbestimmten Annäherungen darstellt.

12. Winkelinterpolationsverfahren nach einem der Ansprüche 1 bis 11, **dadurch gekennzeichnet, dass** die der Winkelposition entsprechende 180° - Zone durch die starken Bits eines Bytes bestimmt wird, das man durch die analoge digitale Umwandlung eines Sinussignal oder eines Kosinussignals erhält, das man durch Lesen der Bahn erhält, wobei man die Umwandlung durch eine Umwandlung eines analogen Signals in ein digitales Signal erreicht.

13. Optische Codiervorrichtung hoher Auflösung umfassend

   - einer Scheibe mit mindestens zwei Bahnen (2a und 2c) umfassend eine feine Trennungsbahn (2c) und eine gröbere Trennungsbahn (2a), wobei die Einteilungstrennung jeder Bahn ein Vielfaches der vorangegangenen Bahn ist,
   - vier Photodetektoren (4, 5, 6 und 7), um jede der genannten Bahnen (2a und 2c) zu lesen und pro Bahn empfindlich Sinussignale in jeweiliger Versetzung um 90° zu erhalten
   - eine Einrichtung zur Umwandlung eines analogen Signals in ein digitales Signal (14), um die erhaltenen Signale zu digitalisieren und die Koordinaten der Anfangswinkelpositionen zu definieren ($X_0$ und $Y_0$),

   **gekennzeichnet durch** einen Rechner zur Berechnung einer dynamischen Winkelinterpolation beginnend mit den Sinussignalen, die **durch** das Lesen der vier Photodetektoren (4, 5, 6 und 7) jeder einzelnen Bahn (2a und 2c) erzeugt und in digitale Signale umgewandelt werden, wobei der Rechner (15) zur Schaffung eines digitalen Winkelwerts für jede einzelne Bahn (2a und 2c) vorgesehen ist und eine Einrichtung zur Annäherung der Berechnung in einem Winkelbereich von - 90° zu 90° aufweist, wobei die Einrichtung zur Annäherung bei jeder Annäherung "i" folgende Schritte durchführt:

   - Bestimmen eines Zeichens "d" als Funktion der Digitalwerte $X_{i-1}$ und $Y_{i-1}$, die zuvor in der vorhergehenden Annäherung berechnet oder gelesen wurden,
   - Berechnen neuer Digitalwerte $X_i$ und $Y_i$ zur Bestimmung des Zeichens "d" in der nächsten Annäherung "i+1" und
   - Berechnen eines Wertes Z, der sich bei jeder Annäherung dem gesuchten Winkelendwert nähert, wobei die optische Codiervorrichtung eine Einrichtung zur Bestimmung des 180°-Bereichs der Winkelposition und zur Bildung eines Bytes, das die absolute Winkelposition der Scheibe darstellt, umfasst.

14. Optische Codiervorrichtung hoher Auflösung nach Anspruch 13, **dadurch gekennzeichnet, dass** die Einrichtung zur Annäherung des Rechners eine Einrichtung zur Bestimmung des Rechenvorgangs der Annäherung i aufweist, die zu/von der orthogonalen Koordinate ($X_i$ oder $Y_i$), jene ($Y_{i-1}$ oder $X_{i-1}$) addiert oder subtrahiert, die in der vorhergehenden Annäherung i-1 berechnet wurden, wobei dieser Vorgang an eine Bedingung der Bestimmung eines Zeichens (d) gebunden ist, das man mittels eines Koordinatenvergleichs der vorhergehenden Annäherung mit einem konstanten Wert erhält, und eine Einrichtung zur Verwendung des Zeichens (d) des so bestimmten Vorgangs, um einen Koeffizienten ($\beta\_i$) in Abhängigkeit von dem Annäherungsniveau vom vorherigen Winkelwert ($Z_{i-1}$) hinzuzufügen oder abzuziehen , um einen gesuchten Winkelwert ($Z_i$) zu erhalten.

15. Optische Codiervorrichtung hoher Auflösung nach Anspruch 13 oder 14, **dadurch gekennzeichnet, dass** die Behandlung der digitalen Signale, die in Sinusform in den Rechner (15) gelangen, ein einer Bahnablesung entsprechendes Byte liefert, wobei dieses Byte ein erstes stellvertretendes Bit der Änderung der lichtundurchlässigen und durchscheinenden Bereiche der abgelesenen Bahn enthält und die anderen verbleibenden Bits stellvertretend für den von einer dynamischen Winkelinterpolationsberechnung gelieferten digitalen Winkelwert bleiben.

16. Optische Codiervorrichtung hoher Auflösung nach einem der Ansprüche 13 bis 15, **dadurch gekennzeichnet, dass** die aus der Behandlung der aus der Ablesung jeder einzelnen Bahn erhaltenen Digitalsignale resultierenden Bytes untereinander kombiniert werden, um so ein synchronisiertes Endbyte erhalten zu können, das die absolute Winkelposition der Scheibe darstellt, wobei das Endbyte so ausgebildet ist, dass die schwachgewichtigen Bits (16c) dem Winkelwert entsprechen, der aus der Bahnablesung des feinsten Abschnitts (2c) resultiert und die schwergewichtigen Bits (16a) dem von der Bahnablesung des gröberen Abschnitts (2a) dargestellten Winkelwert entsprechen.

17. Optische Codiervorrichtung hoher Auflösung nach einem der Ansprüche 13 bis 16, **dadurch gekennzeichnet, dass** sie eine Einrichtung zur Umwandlung eines analogen Signals in ein digitales multiplexes Signal (14) umfasst, das die Digitalisierung der Sinussignale ermöglicht, die durch Ablesen jeder einzelnen Bahn als Funktion des vom Rechner befohlenen Multiplexens erzeugt werden.

18. Optische Codiervorrichtung hoher Auflösung nach einem der Ansprüche 13 bis 17, **dadurch gekennzeichnet, dass** sie ein Behandlungssystem für multiplexe Daten aufweist, das die gleiche dynamische Winkelinterpolation beginnend mit allen Sinussignalen, die durch Ablesen jeder einzelnen Bahn erzeugt werden, ermöglicht.

19. Optische Codiervorrichtung hoher Auflösung nach einem der Ansprüche 13 bis 18, die eine Scheibe mit mehr als zwei Bahnen aufweist, wobei die Bahnen verschiedene, mehr oder weniger feine Abschnitte aufweisen und zueinander gegenüberliegend konzentrisch auf der Scheibe angeordnet sind, wodurch die Abschnittsverteilung jeder Bahn ein mehrfaches der vorausgegangenen Bahn beträgt.

20. Optische Codiervorrichtung hoher Auflösung nach einem der Ansprüche 13 bis 19, **dadurch gekennzeichnet, dass** die gröbere Abschnittsbahn (16a) nach ihrer Ablesung wenigstens ein Sinussignal erzeugt, dessen Zeitabschnitt einer Umdrehung der codierten Scheibe entspricht.

21. Optische Codiervorrichtung hoher Auflösung nach einem der Ansprüche 13 bis 20, **dadurch gekennzeichnet, dass** der lichtundurchlässige Teil der gröberen Abschnittsbahn (16a) eine variierende Radiusstärke gemäß eines bestimmten Gesetzes aufweist und es ermöglicht, durch seine Ablesung ein Sinussignal zu erzeugen.

## Figure 1

## Figure 2

# Figure 3

# Figure 4

# Figure 5

# Figure 6

25

21

24

23

22a

22b

22c

22d

# Figure 7

# Figure 8

# Figure 9